# EUROPEAN PATENT SPECIFICATION

(11) **EP 2 589 055 B1**
(45) Date of publication and mention of the grant of the patent: **25.12.2019**
(21) Application number: 11810082.5
(22) Date of filing: 27.06.2011
(51) Int. Cl.: H01F 38/40, H01L 25/00, H01L 23/64, H01L 23/00, H01L 25/065, H01F 19/08

(54) **GALVANIC ISOLATION TRANSFORMER**
TRANSFORMATOR FÜR GALVANISCHE TRENNUNG
TRANSFORMATEUR À ISOLATION GALVANIQUE

(30) Priority: 30.06.2010 US 827316
(43) Date of publication of application: 08.05.2013
(73) Proprietor: National Semiconductor Corporation, Santa Clara, California 95051 (US)
(72) Inventor: FRENCH, William, San Jose, CA 95117 (US); HOPPER, Peter, J., San Jose, CA 95134 (US); SMEYS, Peter, San Jose, CA 95120 (US); GABRYS, Ann, Santa Clara, CA 95054 (US); ANDERSON, David, I., Saratoga, CA 95070 (US)
(74) Representative: Zeller, Andreas
(86) International application number: PCT/US2011/041951
(87) International publication number: WO 2012/012108

(56) References cited:
- US-A- 5 747 982
- US-A- 6 107 674
- US-A1- 2001 050 607
- US-A1- 2003 042 571
- US-A1- 2008 013 635
- US-A1- 2008 278 275
- US-B1- 7 064 442
- US-B1- 7 064 442

## Description

### FIELD OF THE INVENTION

The present invention relates to galvanic isolation in an electrical system and, in particular, to formation of a galvanic isolation transformer on a quartz substrate.

### BACKGROUND OF THE INVENTION

Any electrical system that includes systems that have different ground references or that have the capability to produce current surges is required to incorporate galvanic isolation to protect both the system and the user.

Galvanic isolation for integrated circuits requires a device that electrically isolates two systems to a high target isolation voltage, e.g. 5kV, but that transmits data between systems that are at different ground potentials. There are a number of solutions available that offer galvanic isolation between two systems. One solution is a multi-die approach that utilizes a transformer between the die that are to be isolated from each other; short pulses generated on one die system are transmitted across the transformer to be decoded by the second die system. Another solution is similar to that just described, but uses a capacitor to isolate the two die systems instead of a transformer. Yet another solution utilizes optical coupling, whereby a light emitting diode (LED) on one die system emits light and a photodiode on the second die system detects the light and generates corresponding electrical current.

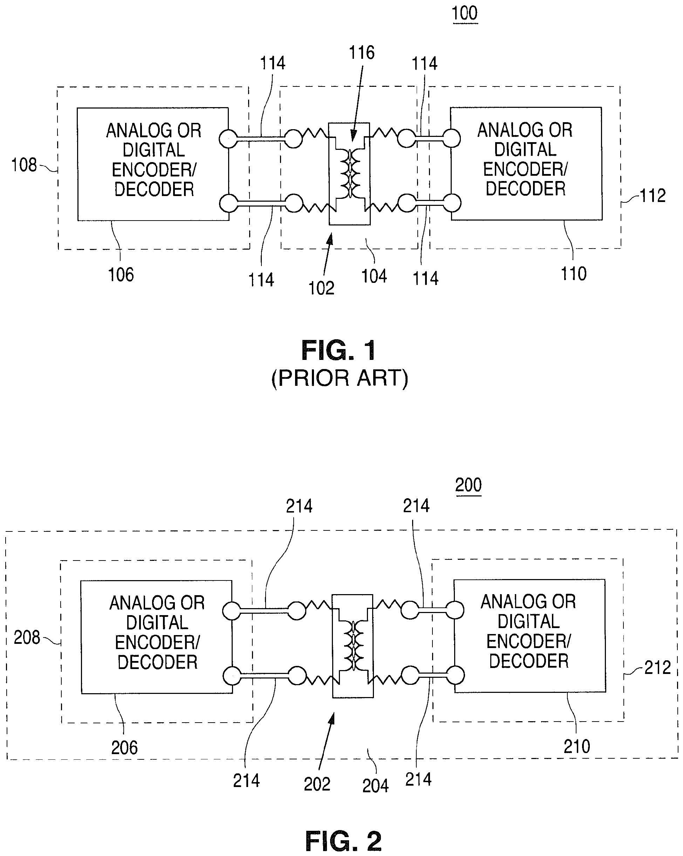

Fig. 1 shows a multi-die galvanic isolation design 100 that utilizes a transformer 102 formed on a single silicon substrate 104 to create galvanic isolation between a first integrated circuit 106 formed on a first silicon die 108 and a second integrated circuit 110 formed on a second silicon die 112. Fig. 1 shows the transformer 102 connected between the first integrated circuit 106 and the second integrated circuit 110 by wire bonds 114 that electrically connect the first silicon die 108 and the second silicon die 112 to the "transformer" substrate 104. The dielectric 116 (shown schematically in Fig. 1) formed between the windings of the transformer 102 must be thick enough to hold off the voltage difference between the first integrated circuit 106 and the second integrated circuit 110. In the Fig. 1 integrated circuit system 100, to transmit data, an analog or digital encoder/decoder included in the first integrated circuit 106 takes data generated by the first integrated circuit 106, encodes it and transmits it across the transformer 102. There are a number of existing methods used to transfer voltage or current across a transformer, e.g., very short, square pulses or via a high frequency rf carrier sinusoidal wave. An analog or digital encoder/decoder included in the second integrated circuit 110 detects the transmitted encoded data, decodes them and extracts the data for utilization by the second integrated circuit 110.

There are two basic types of integrated circuit (IC) transformers commonly utilized in the semiconductor IC industry: an inter-wound planar type and a stacked type. The inter-wound type utilizes a single metal layer and the windings are separated based upon layout design. The stacked type utilizes two layers of metal that are separated by a distance that is great enough to hold off the voltage difference in the two windings.

In order to provide galvanic isolation of, for example an IC having a voltage of greater than or equal to the isolation target voltage of, e.g., 5kV associated therewith, at least four types of isolation are required: winding-to-winding isolation, winding-to-substrate isolation, bond wire-to-bond wire isolation and die-to-die isolation. The minimum distance for winding-to-winding isolation is determined from the dielectric strength of the insulator used between the windings. Table 1 below provides an overview of several dielectric materials commonly utilized in the semiconductor processing and packaging industry and the distance required for isolation of 5kV. Typically, the distances utilized in an actual device are greater to safely account for differences in dielectric quality and uniformity.

**Table 1**

| Material | Dielectric Strength Strength (V/um) | Minimum Space for 5kV Isolation (um) | Dielectric Constant |
|---|---|---|---|
| Cookson Group Plaskon® 7115 Epoxy Molding Compound | 20 | 250 | 3.5 |
| Silicon Dioxide | 250-900 | 20-6 | 3.9 |
| BCB | 530 | 9.5 | 2.65 |
| Polyimide | 200-300 | 25-17 | 3.4 |
| SU8 2000 | 112 | 45 | 3.2-4 |
| Parylene | 220 | 23 | 3.1 |

The minimum distance for winding-to-substrate isolation is determined differently for a stacked transformer and an inter-wound transformer. For a stacked transformer, the high voltage side is in the top metal layer which, by design, is located a sufficient distance from the substrate to avoid dielectric breakdown to the substrate. For an inter-wound transformer, however, the metal layer, i.e. both windings of the transformer, must be sufficiently distanced from the silicon substrate so that dielectric breakdown does not occur at the isolation voltage. The distance is similar to the distances shown in Table 1 and depends upon the material stack between the metal layers and the substrate.

The bond wire-to-bond wire spacing is dictated by the molding compound with which the final package is injected. A typical compound might be the Sumitomo G700 series of molding compounds that has a listed dielectric strength of 15 V/µm. The spacing between bond pads and wires must be sufficiently large that breakdown will never occur in the molding compound. The molding compound is the least well controlled of all materials within the package and, therefore, would introduce too much variation.

The die-to-die breakdown voltage is similarly defined through the molding compound. Typically, integrated circuits are built on silicon substrates on copper leadframes, which means that two silicon die cannot be mounted on the same die attach pad (DAP). This forces the use of two DAP leadframes with a space in between which is subsequently filled with molding compound. Similarly to the wire bonds, the distance between the two DAPs must be sufficient to exceed the rated dielectric withstand voltage. US 7,064,442 relates to an integrated circuit package device. US 2008/0278275 relates to miniature transformers adapted for use in galvanic isolators and the like. US 2001/0050607 relates to an integrated transformer.

### SUMMARY OF THE INVENTION

In an embodiment of the subject matter claimed herein, an integrated circuit system comprises a quartz substrate, a first integrated circuit die system attached to the substrate and having a first voltage associated therewith, a second integrated circuit die system attached to the substrate and having a second voltage associated therewith, the second voltage being less than the first voltage, and a transformer formed on the substrate and electrically connected between the first integrated circuit die system and the second integrated circuit die system to provide galvanic isolation therebetween.

In another embodiment of the subject matter claimed herein, a method of forming an integrated circuit system comprises providing a first integrated circuit die having a first integrated circuit formed thereon, providing a second integrated circuit die having a second integrated circuit formed thereon, and electrically connecting a transformer formed on a quartz substrate between the first integrated circuit and the second integrated circuit to provide galvanic isolation therebetween, wherein the first integrated circuit die and the second integrated circuit die are attached to the quartz substrate.

The features and advantages of the various aspects of the subject matter disclosed herein will be more fully understood and appreciated upon consideration of the following detailed description and the accompanying drawings, which set forth illustrative embodiments in which the concepts of the claimed subject matter are utilized.

### BRIEF DESCRIPTION OF THE DRAWINGS

Fig. 1 is block diagram illustrating utilization of a transformer to provide galvanic isolation between to integrated circuits.
Fig. 2 is a block diagram illustrating utilization of a transformer formed on a quartz substrate to provide galvanic isolation between two integrated circuits.
Fig. 3 is a schematic layout drawing illustrating an inter-wound transformer formed on a quartz substrate.
Fig. 4 is a schematic drawing illustrating the Fig. 3 inter-wound transformer in cross section.
Fig. 5 is a graph showing a comparison of the change in Q factor over frequency of an interwoven transformer on a silicon substrate versus on a quartz substrate.
Fig. 6 is a plan view schematic diagram illustrating an embodiment of a multi-channel system that utilizes a plurality of inter-wound transformers to provide galvanic isolation between two multi-channel integrated circuits.

### DETAILED DESCRIPTION

As discussed above, typical integrated circuit transformer processes for galvanic isolation of high voltage, e.g., voltage levels of equal to or greater than 5kV, require that the high voltage winding of the transformer (interwoven or stacked) be a significant distance above the semiconductor (e.g., silicon) wafer substrate in order to avoid leakage or dielectric breakdown to the substrate. This results in significant additional processing and cost. The subject matter disclosed and claimed herein provides a process whereby a galvanic isolation transformer may be created in one or more layers of metal, but above a quartz wafer rather than a silicon wafer. Quartz, similar to silicon dioxide, is a dielectric isolator, which therefore means that the breakdown from the high voltage winding of the transformer to the substrate is removed.

Fig. 2 shows an integrated circuit system 200 that includes a transformer 202 formed on a quartz substrate 204 and connected between a first integrated circuit 206 formed on a first semiconductor (e.g., silicon) die 208 and a second integrated circuit 210 formed on a second semiconductor (e.g., silicon) die 212. According to the embodiments, both the first semiconductor die 208 and the second semiconductor die 212 are also formed on the quartz substrate 204. The first integrated circuit 206 has a first voltage, e.g., greater than or equal to 5kV, associated therewith and the second integrated circuit 210 has a second voltage associated therewith that is less than the first voltage. Fig. 2 shows wire bonds 214 that electrically connect the transformer 202 between the first integrated circuit 206 and the second integrated circuit 210. In the Fig. 2 integrated circuit system 200, to transmit data, an analog or digital encoder/decoder included in the first integrated circuit 206 takes data generated by the first integrated circuit 206, encodes it and transmits it across transformer 102 utilizing either very short, square pulses or a high frequency carrier; an analog or digital encoder/decoder included in the second integrated circuit 210 detects the pulses, decodes them and extracts the data for utilization by the second integrated circuit 210.

The integrated circuit system design shown in Fig. 2 could be implemented using two die attach paddles (DAPs) inside a package. The DAP would then act as the support for the die. However, this results in difficulty with wire bonds when only a single level of metal is available and higher cost. Therefore, the Fig. 2 design shows the system formed entirely on a single quartz substrate 204. The first silicon die 208 and the second silicon die 212 are attached to the quartz substrate 204 using bond adhesive. Bonding adhesive well known to those skilled in the art can be used to bond quartz to silicon or to a metal plate, e.g. using Cu, can be patterned and the bond is then between the metal plate and the silicon, which is a more standard approach. The advantages to forming the integrated circuit system entirely on the quartz substrate include, but are not limited to: isolation between the three circuits is achieved; a single DAP inside the package can be utilized, thereby simplifying package design; the DAP can be either conductive or non-conductive, whichever is the lowest cost; the ability to use local routing of copper interconnect on quartz, thereby allowing optimal placement of bond pads for wire bonding from the DAP to the leadframe; tighter packaging of die compared with using multiple DAPs inside a package; the two silicon die can also be bumped (pads are metal bumps), flip-chipped and bonded to copper pads defined on the surface of the quartz substrate, thereby reducing the number of wire bonds and reducing parasitic associated therewith.

The transformer 202 may be either an inter-wound type that utilizes a single metal layer and windings that are separated by dielectric material based upon layout design or a stacked type that utilizes two layers of metal that are separated by dielectric material by a distance that is great enough to hold off the voltage difference between the two windings. In both the inter-wound transformer type and the stacked transformer type, the dielectric material may be selected from (but not limited to) the dielectric material identified in Table 1 above. The transformers described herein are air core transformers; however, those skilled in the art will appreciate that the concepts disclosed herein are also applicable to transformers with magnetic cores.

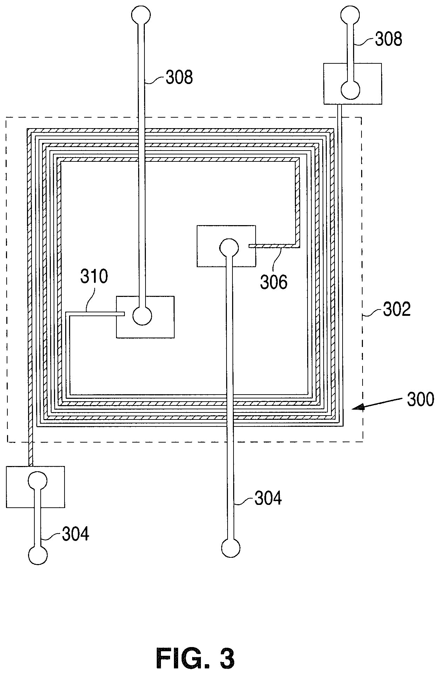

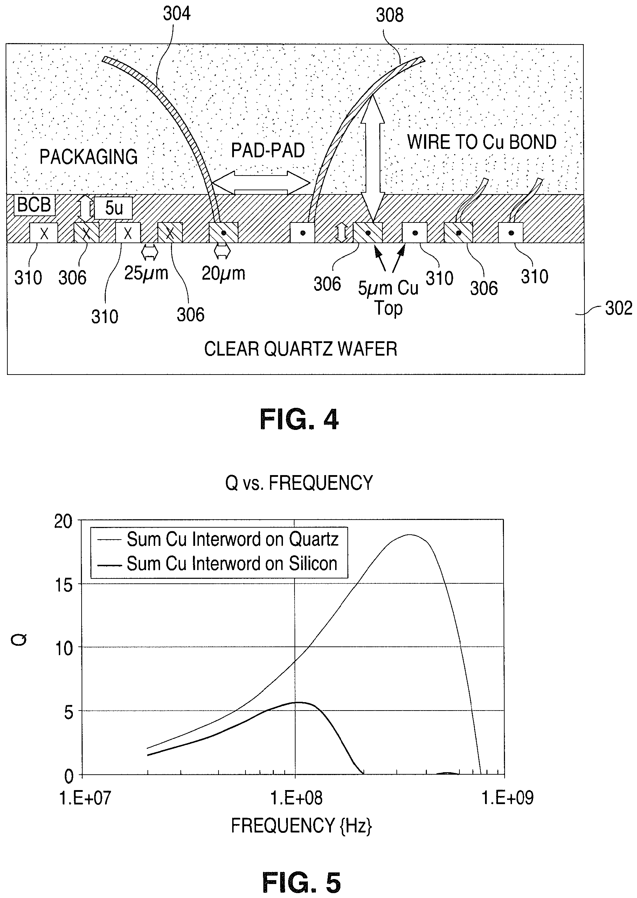

Fig. 3 shows an inter-wound transformer 300 formed on a quartz substrate 302. Wire bonds 304 provide electrical connection between a high voltage integrated circuit (e.g., having a voltage equal to or greater than 5kV associated therewith) formed on a first semiconductor die and a copper high voltage winding 306 of the inter-wound transformer 300. Wire bonds 308 provide electrical connection between a "low" voltage integrated circuit formed on a second semiconductor die and the copper low voltage winding 310 of the inter-wound transformer 300. As stated above, the copper high voltage winding 306 and the copper low voltage winding 310 are separated by a dielectric, e.g., benzocyclobutene (BCB), having a minimum winding separation thickness that is based upon layout design. In an embodiment utilizing BCB, the copper metal width of the transformer windings may be 20µm, the spacing between windings may be 25µm and the thickness of the windings may be 5µm in a transformer having 7/7 turns (not shown in the Fig. 3 schematic drawing), an outer size of 2100x2100µm and an inner size of 800x800µm. Fig. 4 shows a cross section of the Fig. 3 inter-wound transformer 300 with a BCB layer 10µm thick separating turns of the copper high voltage winding 306 and the turns of copper low voltage winding 310.

The processing aspects of the inter-wound planar transformer embodiment 300 shown in Figs. 3 and 4 are advantageous since the copper high voltage winding 304 and the copper low voltage winding may be either plated or deposited directly onto the quartz substrate 302 in accordance with techniques well known to those skilled in the art. Copper adhesion to quartz is very good, as are the stress and wafer bow. As stated above, no dielectric breakdown to the substrate 302 will occur because quartz is an insulator. The dielectric strength of quartz is 25-40 V/µm, which with a 750µm (or greater) thick quartz substrate means that there will be no premature breakdown to the substrate. Before the quartz can be packaged, the wafer is thinned down, e.g. to 16 mils, and care should be taken to ensure that the breakdown voltage to the substrate is maintained above the rated isolation rating.

An additional advantage in using a quartz substrate is in the frequency domain where the common figure of merit, used for inductors, is called "the Q factor" and is defined as the ratio of the Imaginary impedance to the Real impedance. In an inductor or transformer formed on a silicon substrate, as the frequency increases, eddy currents occur in the silicon substrate. This is a well known phenomenon in integrated spiral inductors in silicon. Utilization of a quartz substrate effectively removes the presence of eddy currents and allows the inductor or transformer to attain its maximum possible frequency response. The result is that the maximum Q is greatly increased. (It is noted that those skilled in the art will appreciate that the concepts and subject matter disclosed herein with respect to transformers formed on quartz substrates are equally applicable to inductors formed on quartz substrates.)

Fig. 5 shows the frequency response of the inter-wound transformer 300 on quartz shown in Figs. 3 and 4. As stated above, in this design, the metal is 5µm thick copper, there are 7 windings to the spiral, the metal width is 20µm and the metal-metal spacing is 25µm. The metal is covered by a 10µm thick layer of BCB as a passivation layer. As shown in Fig. 5, the quartz substrate achieves maximum Q at a frequency of 400MHz compared with the same design on a silicon wafer which achieves a frequency of 70MHz. The maximum Q of the quartz substrate is also much higher: 19 in Fig. 5 compared with 10 for the silicon wafer.

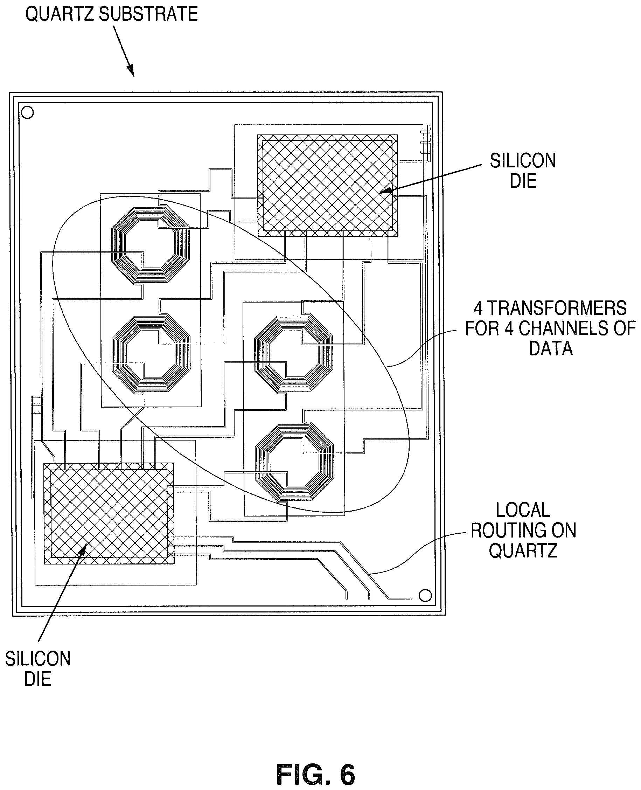

Fig. 6 shows a multi-channel embodiment wherein a high voltage silicon die and a low voltage silicon die, together with four inter-wound transformers, are bonded to a quartz substrate. Although the transformers are shown in Fig. 6 as an inter-wound octaganal design, other inter-woven designs (e.g. the design shown in Figs. 3 and 4)or stacked designs may be utilized. Local routing of copper on quartz is utilized to interconnect the four inter-wound transformers between the high voltage die and the low voltage die. In the Fig. 6 embodiment, the four transformers may be integrated into a 44 Lead PLCC package. This allows the metal pads for the bond wires to be distributed around the edges of the quartz substrate and connected to the transformers using local copper interconnect. Without the use of a common quartz substrate and the local routing of copper interconnected on quartz to distribute wire bond pads, this multi-channel design could not fit into the 44 Lead PLCC package.

## Claims

1. An integrated circuit system comprising:
a quartz substrate (204);
a first integrated circuit die (208) attached to the quartz substrate (204) and having a first integrated circuit (206) formed thereon, the first integrated circuit (206) having a first voltage associated therewith;
a second integrated circuit die (212) attached to the quartz substrate (204) and having a second integrated circuit (210) formed thereon, the second integrated circuit (210) having a second voltage associated therewith, the second voltage being less than the first voltage; and
a transformer system (202) formed on the quartz substrate (204) and electrically connected between the first integrated circuit (206) and the second integrated circuit (210) to provide galvanic isolation therebetween.

2. The integrated circuit system of claim 1, wherein the first voltage is greater than or equal to 5 kV.

3. The integrated circuit system of claim 1, wherein the transformer system (202) comprises an inter-wound transformer.

4. The integrated circuit system of claim 1, wherein the transformer system (202) comprises a stacked transformer.

5. The integrated circuit system of claim 1, wherein the transformer system (202) comprises multiple inter-wound transformers to provide multi-channel signal communication between the first integrated circuit (206) and the second integrated circuit (210).

6. The integrated circuit system of claim 1, wherein
the first integrated circuit (206) includes a first encoder/decoder that encodes data generated by the first integrated circuit (206) and transmits the encoded data to the second integrated circuit (210) via the transformer system (202), and wherein
the second integrated circuit (210) includes a second encoder/decoder that decodes the encoded data transmitted by the first integrated circuit (206) and extracts the data for utilization by the second integrated circuit (210).

7. A method of forming an integrated circuit system comprising:
providing a first integrated circuit die (208) having a first integrated circuit (206) formed thereon;
providing a second integrated circuit die (212) having a second integrated circuit (210) formed thereon; and
electrically connecting a transformer system (202) formed on a quartz substrate (204) between the first integrated circuit (206) and the second integrated circuit (210) to provide galvanic isolation therebetween, wherein the first integrated circuit die (208) and the second integrated circuit die (212) are attached to the quartz substrate (204).

8. The method of claim 7, wherein the transformer system (202) comprises an inter-wound transformer.

9. The method of claim 7, wherein the transformer system (202) comprises a stacked transformer.

10. The method of claim 7, wherein the transformer system (202) comprises multiple inter-wound transformers to provide multi-channel signal communication between the first integrated circuit (206) and the second integrated circuit (210).

## Patentansprüche

1. Integriertes Schaltungssystem, das Folgendes umfasst:
ein Quarzsubstrat (204);
einen ersten integrierten Schaltungschip (208), der am Quarzsubstrat (204) angebracht ist und eine erste integrierte Schaltung (206) besitzt, die auf ihm gebildet ist, wobei der ersten integrierten Schaltung (206) eine erste Spannung zugeordnet ist;
einen zweiten integrierten Schaltungschip (212), der am Quarzsubstrat (204) angebracht ist und eine zweite integrierte Schaltung (210) besitzt, die auf ihm gebildet ist, wobei der zweiten integrierten Schaltung (210) eine zweite Spannung zugeordnet ist und die zweite Spannung kleiner als die erste Spannung ist; und
ein Transformatorsystem (202), das auf dem Quarzsubstrat (204) gebildet ist und zwischen der ersten integrierten Schaltung (206) und der zweiten integrierten Schaltung (210) elektrisch verbunden ist, um dazwischen eine galvanische Isolation bereitzustellen.

2. Integriertes Schaltungssystem nach Anspruch 1, wobei die erste Spannung größer oder gleich 5 kV ist.

3. Integriertes Schaltungssystem nach Anspruch 1, wobei das Transformatorsystem (202) einen übergreifend gewickelten Transformator umfasst.

4. Integriertes Schaltungssystem nach Anspruch 1, wobei das Transformatorsystem (202) einen gestapelten Transformator umfasst.

5. Integriertes Schaltungssystem nach Anspruch 1, wobei das Transformatorsystem (202) mehrere übergreifend gewickelte Transformatoren umfasst, um eine Mehrkanalsignalkommunikation zwischen der ersten integrierten Schaltung (206) und der zweiten integrierten Schaltung (210) bereitzustellen.

6. Integriertes Schaltungssystem nach Anspruch 1, wobei
die erste integrierte Schaltung (206) einen ersten Codierer/Decodierer enthält, der Daten codiert, die durch die erste integrierte Schaltung (206) erzeugt werden, und mittels des Transformatorsystems (202) die codierten Daten zur zweiten integrierten Schaltung (210) sendet, und
die zweite integrierte Schaltung (210) einen zweiten Codierer/Decodierer enthält, der die codierten Daten, die durch die erste integrierte Schaltung (206) gesendet wurden, decodiert und die Daten zur Verwendung durch die zweite integrierte Schaltung (210) extrahiert.

7. Verfahren zum Bilden eines integrierten Schaltungssystems, das Folgendes umfasst:
Bereitstellen eines ersten integrierten Schaltungschip (208), der eine erste integrierte Schaltung (206) besitzt, die auf ihm gebildet ist;
Bereitstellen eines zweiten integrierten Schaltungschip (212), der eine zweite integrierte Schaltung (210) besitzt, die auf ihm gebildet ist; und
elektrisches Verbinden eines Transformatorsystems (202), das auf dem Quarzsubstrat (204) gebildet ist, zwischen der ersten integrierten Schaltung (206) und der zweiten integrierten Schaltung (210), um eine galvanische Isolation dazwischen bereitzustellen, wobei der erste integrierte Schaltungschip (208) und der zweite integrierte Schaltungschip (212) am Quarzsubstrat (204) angebracht sind.

8. Verfahren nach Anspruch 7, wobei das Transformatorsystem (202) einen übergreifend gewickelten Transformator umfasst.

9. Verfahren nach Anspruch 7, wobei das Transformatorsystem (202) einen gestapelten Transformator umfasst.

10. Verfahren nach Anspruch 7, wobei das Transformatorsystem (202) mehrere übergreifend gewickelte Transformatoren umfasst, um eine Mehrkanalsignalkommunikation zwischen der ersten integrierten Schaltung (206) und der zweiten integrierten Schaltung (210) bereitzustellen.

## Revendications

1. Système de circuit intégré comprenant :
un substrat de quartz (204) ;
une première puce de circuit intégré (208) fixée au substrat de quartz (204) et ayant un premier circuit intégré (206) formé sur celui-ci, le premier circuit intégré (206) ayant une première tension associée à celui-ci ;
une seconde puce de circuit intégré (212) fixée au substrat de quartz (204) et ayant un second circuit intégré (210) formé sur celui-ci, le second circuit intégré (210) ayant une seconde tension associée à celui-ci, la seconde tension étant inférieure à la première tension ; et
un système de transformateur (202) formé sur le substrat de quartz (204) et connecté électriquement entre le premier circuit intégré (206) et le second circuit intégré (210) pour fournir une isolation galvanique entre eux.

2. Système de circuit intégré selon la revendication 1, la première tension étant supérieure ou égale à 5 kV.

3. Système de circuit intégré selon la revendication 1, le système de transformateur (202) comprenant un transformateur inter-enroulé.

4. Système de circuit intégré selon la revendication 1, le système de transformateur (202) comprenant un transformateur empilé.

5. Système de circuit intégré selon la revendication 1, le système de transformateur (202) comprenant de multiples transformateurs inter-enroulés pour fournir une communication de signaux multicanaux entre le premier circuit intégré (206) et le second circuit intégré (210).

6. Système de circuit intégré selon la revendication 1,
le premier circuit intégré (206) comprenant un premier codeur/décodeur qui code des données générées par le premier circuit intégré (206) et transmet les données codées au second circuit intégré (210) par l'intermédiaire du système de transformateur (202), et
le second circuit intégré (210) comprenant un second codeur/décodeur qui décode les données codées transmises par le premier circuit intégré (206) et extrait les données pour utilisation par le second circuit intégré (210).

7. Procédé de formation d'un système de circuit intégré comprenant :
la fourniture d'une première puce de circuit intégré (208) ayant un premier circuit intégré (206) formé sur celle-ci ;
la fourniture d'une seconde puce de circuit intégré (212) ayant un second circuit intégré (210) formé sur celle-ci ; et
la connexion électrique d'un système de transformateur (202) formé sur un substrat de quartz (204) entre le premier circuit intégré (206) et le second circuit intégré (210) pour fournir une isolation galvanique entre eux, la première puce de circuit intégré (208) et la seconde puce de circuit intégré (212) étant fixées au substrat de quartz (204).

8. Procédé selon la revendication 7, le système de transformateur (202) comprenant un transformateur inter-enroulé.

9. Procédé selon la revendication 7, le système de transformateur (202) comprenant un transformateur empilé.

10. Procédé selon la revendication 7, le système de transformateur (202) comprenant de multiples transformateurs inter-enroulés pour fournir une communication de signaux multicanaux entre le premier circuit intégré (206) et le second circuit intégré (210).
